(19) **Europäisches Patentamt**

**European Patent Office**

**Office européen des brevets**

(11) **EP 1 533 843 A2**

(12) **EUROPEAN PATENT APPLICATION**

(43) Date of publication:
**25.05.2005 Bulletin 2005/21**

(51) Int Cl.$^7$: **H01L 27/00**

(21) Application number: **04090450.0**

(22) Date of filing: **19.11.2004**

(84) Designated Contracting States:
**AT BE BG CH CY CZ DE DK EE ES FI FR GB GR HU IE IS IT LI LU MC NL PL PT RO SE SI SK TR**
Designated Extension States:
**AL HR LT LV MK YU**

(30) Priority: **20.11.2003 KR 2003082635**

(71) Applicant: **Samsung OLED Co., Ltd.
Uljoo-gun, Ulsan-si (KR)**

(72) Inventors:
• **Heo, Se-Jun
  Busan-si (KR)**
• **Nam, Wi-Jin
  Geumjeong-gu Busan-si (KR)**

(74) Representative:
**Hengelhaupt, Jürgen, Dipl.-Ing. et al
Anwaltskanzlei
Gulde Hengelhaupt Ziebig & Schneider
Wallstrasse 58/59
10179 Berlin (DE)**

(54) **Electroluminescence device having lead line with low resistance**

(57) An organic electroluminescence device including a plurality of electrodes formed on a substrate, and a plurality of lead lines are coupled to the plurality of electrodes. At least two or more lead lines among the plurality of lead lines have different widths, and a width of a longer lead line among the plural lead lines is greater than a width of a shorter lead line.

**EP 1 533 843 A2**

## Description

This application claims the benefit of Korean Patent Application No. 2003-82635, filed on November 20, 2003, which is hereby incorporated by reference for all purposes as if fully set forth herein.

## BACKGROUND OF THE INVENTION

### Field of the Invention

The present invention relates to an electroluminescence device, and more particularly, to an electroluminescence device having lead lines that are connected to a plurality of electrodes forming an electroluminescence unit, the lead lines having different widths corresponding to lengths thereof.

### Discussion of the Related Art

Many different types of display apparatuses are used to display images. Flat panel displays are replacing the conventional cathode ray tube (CRT) devices. Flat panel displays are either emissive type or non-emissive type depending upon how the panel emits light. A flat CRT, a plasma display panel device, a vacuum fluorescent display device, a field emission display device, and an electroluminescence (EL) display device are emissive type display device. A liquid crystal display device is a non-emissive type display device.

An organic EL display device is an emissive type display device that uses a phenomenon in which positive electrodes and negative electrodes inject electrons and holes, into an organic thin film, that combine to form exitons, which generate light of a certain wavelength. The organic EL display device may be driven with a low voltage, formed in a thin plate type with light weight, has a wide viewing angle and a fast response speed.

An organic EL device may include positive electrodes, an organic layer, and negative electrodes that are stacked on a substrate. The substrate is typically formed using a glass, however, in some cases, a bendable plastic or a bendable film may be used. Indium tin oxide (ITO) may be used as the positive electrode, which may be formed through a vacuum deposition method or a sputtering method. Magnesium (Mg), lithium (Li), and other similar substances that have a low work function may be used as the negative electrode. The organic layer may be formed using various organic materials, and it may be doped by fluorescence dye or phosphorescence dye to improve its light emitting efficiency. The organic layer may include an organic emitting layer (EML), where the holes and electrons combine to form exitons and emit light. In order to improve the light emitting efficiency, the holes and electrons should be smoothly transported to the organic EML. Thus an electron transport layer (ETL) may be disposed between the negative electrode and the organic EML, and a hole transport layer (HTL) may be disposed between the positive electrode and the organic EML. Additionally, a hole injection layer (HIL) may be disposed between the positive electrode and the ETL, and an electron injection layer (EIL) may be disposed between the negative electrode and the ETL.

For example, the ITO electrode may be formed on a glass substrate by a sputtering process, the organic EML and the metal electrodes may be formed in an evaporation method in a vacuum using a deposition apparatus including a chamber, a material evaporation source, a thickness monitor, and a metal mask. A desiccant is then injected into the organic OL device, and the device is sealed under a vacuum or nitrogen atmosphere, thereby increasing its durability, which is adversely affected by moisture and oxygen.

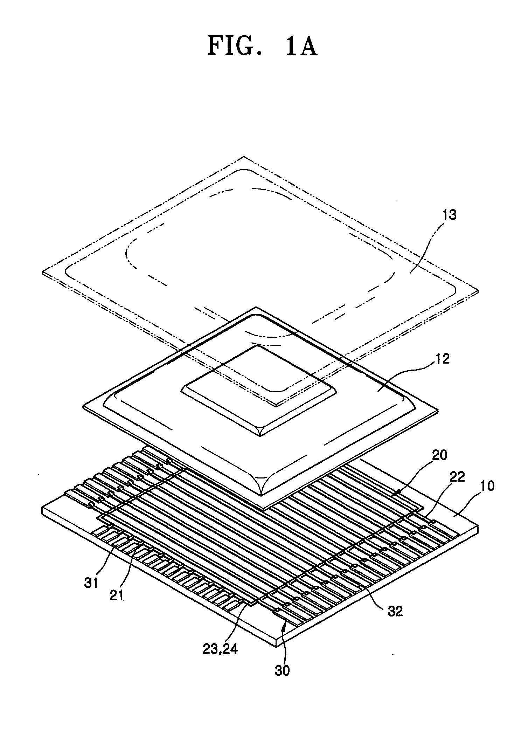

FIG. 1A is an exploded perspective view showing a configuration of a conventional organic EL device. As shown in FIG. 1A, the organic EL device includes a substrate 10, and an active area 20 that is formed on a surface of the substrate 10 to form images. A cap 12 is bonded with the substrate to cover and seal the active area 20, and an electrode terminal portion 30, for supplying electric current to the active area 20, extends to the outer portion of the cap 12. A flexible printed circuit board (PCB) 13 is joined on the terminal unit 30, at a portion not covered by the cap 12, and is coupled to a circuit portion (not shown) for driving the active area 20. The electrode terminal portion 30 includes a first electrode terminal unit 31 and a second electrode terminal unit 32.

The active area 20 includes stripe-shaped first electrode lines 21 that are connected to the first electrode terminal unit 31 and spaced at predetermined intervals as positive electrodes. Organic layers 24 are deposited on the first electrode lines 21 in predetermined patterns, and second electrode lines 22, insulated from the first electrode lines 21, are electrically coupled to the second electrode terminal unit 32, and formed on an upper portion of the organic layers 24 as negative electrodes. Additionally, the active area 20 includes an insulating layer 23 that prevents the first electrode lines 21 and the second electrode lines 23 from short circuiting.

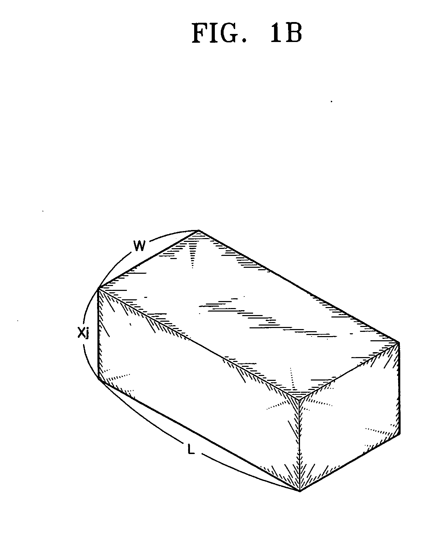

Since the organic EL device is a current driving device, its light emitting efficiency is closely related to the first and second electrode lines on the active area and the resistance of the lines out of the active area. If the active area electrode lines have a high resistance, this may cause a voltage drop that generates a brightness difference between the pixels, thereby lowering image quality. Thus, many methods for reducing the electrode line resistance on the active area have been suggested. Japanese Laid-open Patent No. 2002-8871 discloses a conductive thick portion that is thicker than the active area electrode lines in order to reduce the resistance of the lead lines besides the first electrode lines and the second electrode lines on the active area. Generally, as shown in FIG. 1B, the following equation may be used to determine the resistance of a lead line on a terminal portion having a width (w), a thickness (xj), and a length (L).

$$R = \rho \frac{l}{x_j w} = R_s \frac{l}{w},$$

where $\rho$ denotes a specific resistance, $x_j$ denotes a thickness of the lead line, w denotes a width of the lead line, and $R_s$ denotes a sheet resistance. As disclosed in the conventional art, the resistance may be reduced by additionally forming the conductive thick portion with respect to the lead lines. However, the thickness of the lead line may need to be increased significantly in order to satisfy the required degree of resistance decrease. Thus, it is difficult to manufacture the organic EL device, and the thicker lines may generate structural problems.

Also, a plurality of lead lines will typically have the same width and length. But when the lead lines of the terminal portion are disposed densely to improve substrate mounting convenience and the convenience of arranging other elements on the substrate, the lengths of the lead lines will differ, therefore, resistances will differ. As lead line length increases, the resistance difference and the voltage drop also increase. Therefore, the organic EL device's driving voltage and power consumption increase.

## SUMMARY OF THE INVENTION

The present invention provides an organic electroluminescence (EL) device including a plurality of lines having widths corresponding to lengths thereof so that the different length lead lines may have uniform resistance.

Additional features of the invention will be set forth in the description which follows, and in part will be apparent from the description, or may be learned by practice of the invention.

The present invention discloses an organic EL device including a plurality of electrodes formed on a substrate, and a plurality of lead lines are coupled to the plurality of electrodes. At least two or more lead lines among the plurality of lead lines have different widths, and a longer lead line among the plural lead lines has a larger width than a width of a shorter lead line.

The present invention also discloses a flat panel display device including a substrate, on which a plurality of electrodes are disposed, and a plurality of lead lines coupled to the plurality of electrodes. At least two or more lead lines among the plurality of lead lines have different widths, and a width of a longer lead line is greater than a width of a shorter lead line.

It is to be understood that both the foregoing general description and the following detailed description are exemplary and explanatory and are intended to provide further explanation of the invention as claimed.

## BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention.

FIG. 1A is an exploded perspective view of a conventional organic electroluminescence (EL) device.

FIG. 1B shows a conductive element having a predetermined size.

FIG. 2A is an exploded perspective view of an organic EL device according to an exemplary embodiment of the present invention.

FIG. 2B is a plan view of an enlarged part of the organic EL device of FIG. 2A.

FIG. 3 is a cross-sectional view taken along line A-A of FIG. 2B.

## DETAILED DESCRIPTION OF THE INVENTION

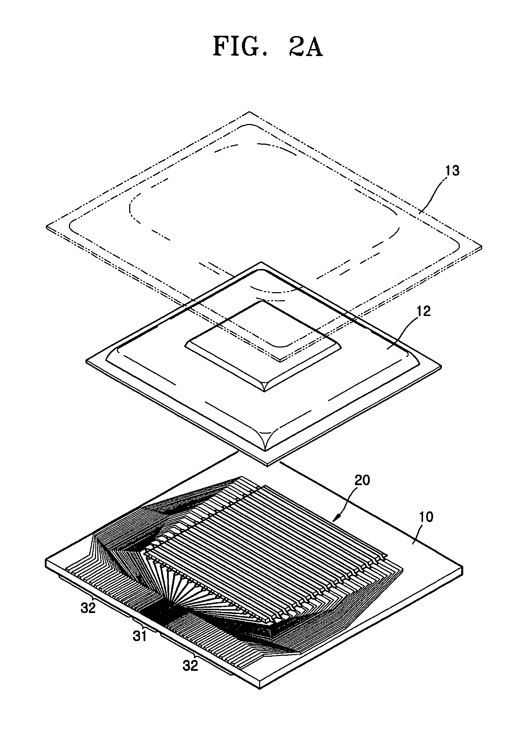

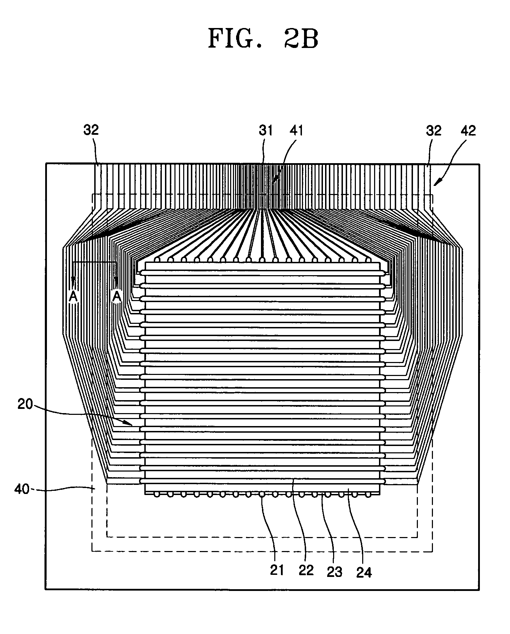

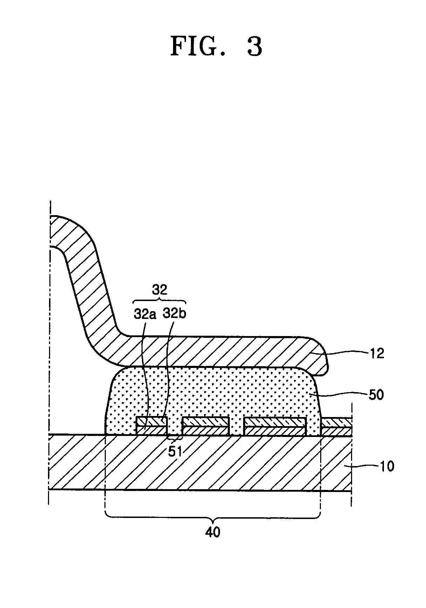

FIG. 2A is an exploded perspective view of a organic electroluminescence (EL) device according to an exemplary embodiment of the present invention and FIG. 2B is a plan view showing an enlarged part of the organic EL device of FIG. 2A. Referring to FIG. 2A and FIG. 2B, an organic EL device of this exemplary embodiment of the present invention includes a substrate 10, on which a plurality of electrodes (or electrode lines) forming an active area 20 are disposed. A cap 12 contains a desiccant and is sealed with the substrate 10 to prevent the active area 20 from being infiltrated by moisture, and a flexible printed circuit board (PCB) 13 connects the organic EL device to a circuit driving unit (not shown). The cap and substrate may be joined at area 40. A plurality of electrode lines include a plurality of first electrode lines 21 as positive electrodes and a plurality of second electrode lines 22 as negative electrodes. The first electrode lines 21 are connected to first lead lines 31 having a first terminal unit 41, and the second electrode lines 22 are connected to second lead lines 32 having a second terminal unit 42. As shown in FIG. 3, the second lead lines 32 may be manufactured to include an indium tin oxide (ITO) portion 32a and a metal or alloy portion 32b. Lead lines 31 may be similarly manufactured. The metal or alloy portion 32b may be formed of metal or alloy having low resistance, such as Cr, Al, Ag, Au, Pt, Pd, Ni, Mo, Ta, Ti, W, C, Fe, In, Ag-Mg, Zn, or other like substances.

The first lead lines 31 and the second lead lines 32 may be lead lines of 1-pad type. As shown in FIG. 2A and FIG. 2B, they may also be formed on a single side of the substrate. In order to minimize lead line resistance, first lead lines 31 and second lead lines 32 have minimum lengths and different widths. Specifically, in order to compensate for the resistance difference caused by different lead line lengths, a longer lead line may have a wider width at its terminal unit portion than that of a shorter lead line. The lengths of the first and second lead lines 31 and 32 may be controlled by passing the lead lines through appropriate positions.

In some cases, the ratio of the length of a first lead line 31 to the width of its first terminal unit 41 may be the same for the first lead lines 31, and the ratio of the length of a second lead line 32 to the width of its second terminal unit 42 may be the same for the second lead lines 32.

In the other cases, the widths of the first terminal unit 41 and the second terminal unit 42 can be maintained in an arithmetic sequence relation with respect to the shortest lead line. That is, since the lead line passes through the outer circumference of the active area 20 to minimize its length, the lengths of the second lead lines 32 increase sequentially. Thus it is desirable that the widths of the second terminal unit 42 increase correspondingly to the lengths of the second lead lines 32. Therefore, assuming that the length of the shortest second lead line 32 is X, where the shortest lead line is the line that is connected to the first line among the second electrode lines 22 and disposed adjacent to the first lead line 31, the length of the second lead lines 32 that are connected to subsequent second electrode lines 22 may be set in a relation such as X+Y, X+2Y, X+3Y,...., X+nY. The above relation may also be applied to the first lead lines 31.

As shown in FIG. 3, a sealing agent 50 is applied on an area 40 where the substrate 10 and the cap 12 contact each other. In order to improve the adhesiveness between the substrate 10 and the cap 12, and to help prevent moisture from entering the active area, the sealing agent 50 directly contacts the substrate portions 51 between the second lead lines 32 and an end portion of the cap 12, and the sealing agent 50 is hardened by irradiation with an ultraviolet (UV) ray. Since the lead lines on the area where the UV ray is irradiated have higher resistances than those of the other area, their widths may be wider by as much as a predetermined set value in order to reduce the resistance difference. The predetermined set value may reduce the resistance difference while minimizing the width increase. Preferably, in the lead lines having widths increasing in a relation of arithmetic sequence corresponding to increasing lengths, the width of a lead line on the area where the UV ray is irradiated is two-thirds wider than that of a lead line out of the UV ray irradiated area. Additionally, the distance of the substrate portion 51 between the second lead lines 32 is set to be about 18μm or less, which may help to maintain the adhesiveness between the sealing agent 50 and the substrate portion 51, as well as reduce the space between lead lines. The width of the metal portion 32b may be about 50μm or less in consideration of the set intervals between them.

Terminal unit widths that ensure different length lead lines have the same resistance may not be achievable because the side of the substrate 10, on which they are located, may not be wide enough to accommodate all terminal units having those desired widths. Therefore, terminal unit width may be controlled to minimize the resistance difference between the lead lines and keep the necessary space between terminal units. In this case, the resistance difference between the terminal units may be limited to a predetermined value to prevent it from increasing the organic EL device's driving voltage. The resistance difference between the lead line having the maximum resistance value and the lead line having the minimum resistance value may be less than 30% of the maximum resistance value. In other words, the lead line having the least resistance may have a resistance that is greater than 70% of the maximum resistance. This relationship applies for the first lead lines and for the second lead lines.

The exemplary embodiment of the present invention shown FIG. 2A and FIG. 2B shows 1-pad type wiring, in which the terminal units are concentrated on one side of the substrate 10. However, the present invention is not limited thereto. It may be applied to any case where the difference between lengths of a plurality of lead lines generates a difference in lead line resistance.

While the above description is made in reference to an electroluminescent display device, the present invention is not limited thereto. The present invention may also be applicable to flat panel display devices having lead lines with widths corresponding to their lengths.

According to exemplary embodiments of the present invention, different length lead lines are coupled to the electrodes forming an organic EL unit. The terminal units have a width corresponding to lead line length, thereby minimizing the resistance difference between a plurality of lead lines caused by their different lengths. Additionally, a plurality of electrode lines, to which the plurality of lead lines are connected, may be formed with nearly equal resistances, thereby providing an EL device requiring a low driving voltage.

Also, in the EL device according to exemplary embodiments of the present invention, a width of the lead line, to which ultraviolet ray (UV) is irradiated, may be changed as much as a predetermined value to compensate for the resistance difference between lead lines caused by the UV irradiating operation, thereby reducing brightness difference between pixels.

Thus, the brightness may be improved by about 20%, and a short rate between pixels can be reduced greatly, thereby increasing the EL device's service life.

It will be apparent to those skilled in the art that various modifications and variation can be made in the present invention without departing from the spirit or scope of the invention. Thus, it is intended that the present invention cover the modifications and variations of this invention provided they come within the scope of the appended claims and their equivalents.

## Claims

1. An organic electroluminescence (EL) device, comprising:

   a plurality of electrodes formed on a substrate; and
   a plurality of lead lines coupled to the plurality of electrodes,

   wherein at least two or more lead lines have different widths, and a width of a longer lead line is greater than a width of a shorter lead line.

2. The organic EL device of claim 1, wherein a ratio of length to width of the plurality of lead lines is about equal.

3. The organic EL device of claim 2, wherein the plurality of lead lines are formed on one side of the substrate.

4. The organic EL device of claim 1, wherein widths of the plurality of lead lines are in a relation of arithmetic sequence with respect to a width of a shortest lead line.

5. The organic EL device of claim 4, wherein the plurality of lead lines are formed on one side of the substrate.

6. The organic EL device of claim 4, wherein a width of a lead line contacting a sealing agent is greater than a width of a lead line not contacting a sealing agent.

7. The organic EL device of claim 6, wherein the width of a lead line contacting a sealing agent is greater by 2/3 of the width that is set in a relation of the arithmetic sequence.

8. The organic EL device of claim 6, wherein a distance between lead lines contacting the sealing agent is about 18μm or less.

9. The organic EL device of claim 8, wherein a width of a lead line contacting the sealing agent is about 50μm or less.

10. The organic EL device of claim 1, wherein a resistance difference between a lead line having a highest resistance and a lead line having a lowest resistance is within a 30% range of the highest resistance.

11. The organic EL device of claim 10, wherein the plurality of lead lines are formed on a one side of the substrate.

12. A flat panel display device, comprising:

    a substrate, on which a plurality of electrodes are disposed; and
    a plurality of lead lines coupled to the plurality of electrodes,

    wherein at least two or more lead lines have different widths, and a width of a longer lead line is greater than a width of a shorter lead line.

13. An organic electroluminescence (EL) device, comprising:

    a plurality of first electrodes and a plurality of second electrodes formed on a substrate;
    a plurality of first lead lines, having first terminal units, coupled to the plurality of first electrodes;
    a plurality of second lead lines, having second terminal units, coupled to the plurality of second electrodes;

    wherein at least two or more first terminal units have different widths, and a width of the first terminal unit of a longer first lead line is greater than a width of the first terminal unit of a shorter first lead line,
    wherein at least two or more second terminal units have different widths, and a width of the second terminal unit of a longer second lead line is greater than a width of the second terminal unit of a shorter second lead line.

14. The organic EL device of claim 13, wherein a ratio of length of a first lead line to width of a first terminal unit is the same for the plurality of first lead lines, and a ratio of length of a second lead line to width of a second terminal unit is the same for the plurality of second lead lines.

15. The organic EL device of claim 13, wherein widths of the plurality of first lead lines are in a relation of arithmetic sequence with respect to a length of a shortest first lead line, and widths of the plurality of second lead lines are in a relation of arithmetic sequence with respect to a length of a shortest second lead line.

16. The organic EL device of claim 15, wherein a width of a second lead line at a point where the second lead line contacts a sealing agent is greater than a width of a second lead line not contacting the sealing agent.

17. The organic EL device of claim 16, wherein the width of the second lead line at the point where the second line contacts the sealing agent is 2/3 greater than the width that is set in the relation of the arithmetic sequence.

18. The organic EL device of claim 17, wherein a distance between second lead lines contacting the sealing agent is about 18 $\mu$m or less.

19. The organic EL device of claim 18, wherein a width of the second lead lines contacting the sealing agent is about 50$\mu$m or less.

20. The organic EL device of claim 13, wherein a resistance difference between a second lead line having a highest resistance and a second lead line having a lowest resistance is within a 30% range of the highest resistance.

FIG. 1A

FIG. 1B

FIG. 2A

# FIG. 2B

FIG. 3